(19) **Europäisches Patentamt**

**European Patent Office**

**Office européen des brevets**

(11) **EP 1 503 500 B1**

(12) **EUROPEAN PATENT SPECIFICATION**

(45) Date of publication and mention
of the grant of the patent:
**28.06.2006 Bulletin 2006/26**

(51) Int Cl.:
***H03L 7/16*** (2006.01)

(21) Application number: **04447092.0**

(22) Date of filing: **08.04.2004**

(54) **A phase-locked loop**

Phasenregelkreis

Boucle à verrouillage de phase

(84) Designated Contracting States:
**AT BE BG CH CY CZ DE DK EE ES FI FR GB GR
HU IE IT LI LU MC NL PL PT RO SE SI SK TR**

(30) Priority: **28.07.2003 EP 03447199**

(43) Date of publication of application:
**02.02.2005 Bulletin 2005/05**

(73) Proprietor: **Op 't Eynde, Frank, Dr.-Ir.
3012 Wilsele-Leuven (BE)**

(72) Inventor: **Op 't Eynde, Frank, Dr.-Ir.
3012 Wilsele-Leuven (BE)**

(74) Representative: **pronovem
Office Van Malderen
Ave. Josse Goffin 158
1082 Brussels (BE)**

(56) References cited:
**EP-A- 0 643 476 US-A- 4 687 999
US-A- 5 218 324**

- **RAZAVI B: "Challenges in the design of
frequency synthesizers for wireless
applications" CUSTOM INTEGRATED CIRCUITS
CONFERENCE, 1997., PROCEEDINGS OF THE
IEEE 1997 SANTA CLARA, CA, USA 5-8 MAY 1997,
NEW YORK, NY, USA,IEEE, US, 5 May 1997
(1997-05-05), pages 395-402, XP010235331 ISBN:
0-7803-3669-0**

**Description**

## Description of the problem

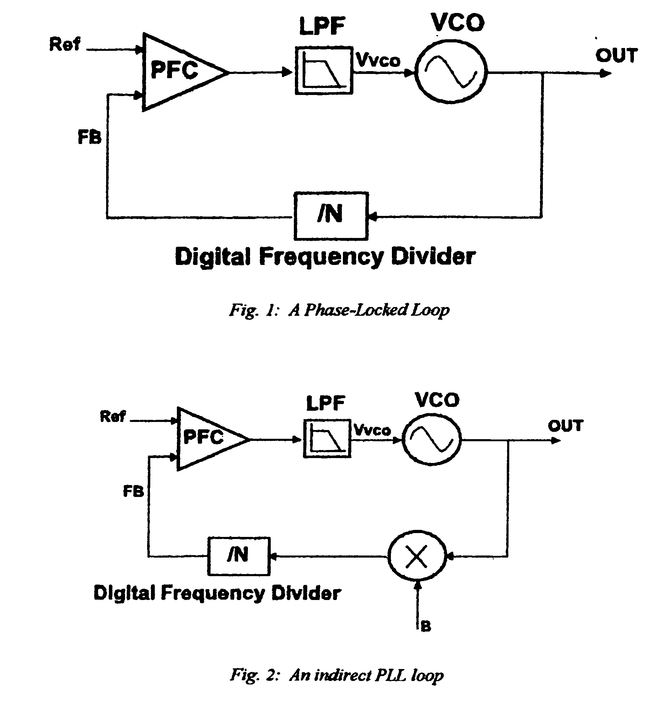

A Phase Locked loop (PLL) is an electronics circuit, intended to generate an electrical signal with a given frequency. An example of such a circuit is depicted in Fig. 1. The PLL mainly contains a Voltage-controlled Oscillator (VCO), a frequency divider (/N), a Phase-comparator (or Phase-Frequency comparator - PFC [1]) and a loop filter (LPF). The basic function of PFC is to control the VCO input signal $V_{vco}$ in such a way that the two inputs *Ref* and *FB* evolve to a state where they are oscillating in phase and hence, their frequencies are equal. This is called the "locked" state. When the loop is locked, this means that:

$$f_{FB} = f_{ref} \quad \text{and hence:} \quad \frac{1}{N} \cdot f_{OUT} = f_{ref} \quad \text{and} \quad f_{OUT} = N \cdot f_{ref} \qquad (1)$$

[1] Some PLLs contain also a block called "Charge Pump". In this text, we consider this charge pump as part of the PFC.
This PLL can be used to create an output signal with a frequency that is N times larger than the frequency of the reference signal[2] .
[2] A PLL can be used for other purposes, such as FM modulation or demodulation, phase (de)modulation or clock recovery. These items are beyond the scope of this explanation, although the present invention can be used also in these domains.
When N is integer, this called an "Integer-*N*" synthesizer. When N is a non-integer value, this is called a "Fractional-*N*" synthesizer.
Under some circumstances, it is useful to create an output signal with a frequency given by:

$$f_{out} = f_B + N \cdot f_{ref} \quad \text{or} \quad f_{out} = f_B - N \cdot f_{ref} \qquad (2)$$

[1] Some PLLs contain also a block called "Charge Pump". In this text, we consider this charge pump as part of the PFC.
[2] A PLL can be used for other purposes, such as FM modulation or demodulation, phase (de)modulation or clock recovery. These items are beyond the scope of this explanation, although the present invention can be used also in these domains.
This can be established with the circuit of Fig. 2. This circuit is identical to the circuit of Fig. 1, except for the addition of a mixer. In the mixer, the two input signals *OUT* and *B* are multiplied. If both signals are sinusoidal signals with frequencies $f_{out}$ and $f_B$ respectively, the mixer output signal consist of a sum of two sinusoidal signals with frequencies $f_{out} + f_B$ and $f_{out} - f_B$. If the PLL loop can lock to the second one, the condition for lock is given by:

$$f_{ref} = f_{FB} = \frac{1}{N} \cdot (f_{out} - f_B) \quad \text{and hence,} \quad f_{out} = f_B + N \cdot f_{ref} \qquad (3)$$

This expression describes the PLL lock condition, when $f_{out}$ is larger than $f_B$. When $f_{out}$ is below $f_B$, the lock condition becomes:

$$f_{ref} = f_{FB} = \frac{1}{N} \cdot (f_B - f_{out}) \quad \text{and hence,} \quad f_{out} = f_B - N \cdot f_{ref} \qquad (4)$$

This principle is well-known as an "indirect synthesizer". It is described in "Low-Phase-Noise Fully-Integrated Frequency Synthesizer" by Jan Craninckx (PhD thesis, KU Leuven, 1997) and in an article from Mr. B. Razavi in the 1997 Custom Integrated Circuits Conference "Challenges in the Design of Frequency Synthesizers for Wireless Applications; pp. 395-402.
However, there are several problems related to this principle:

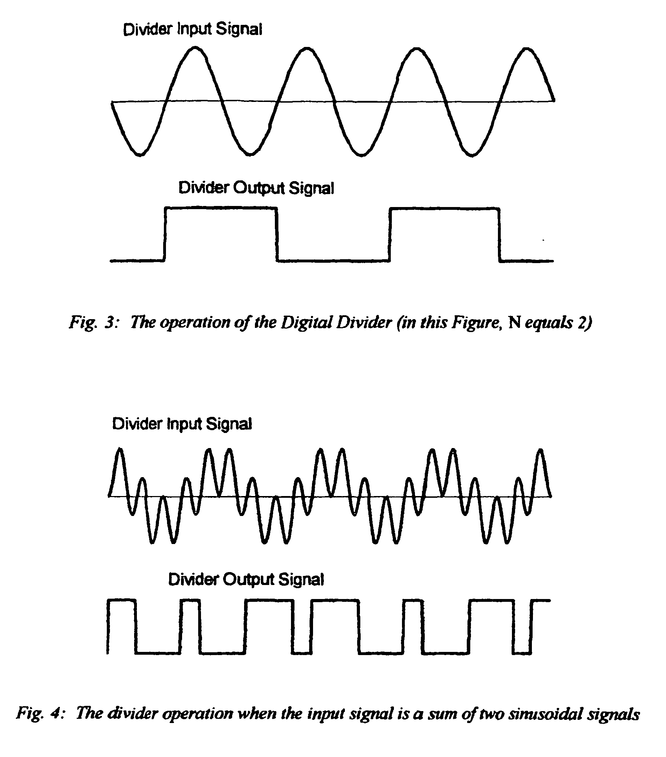

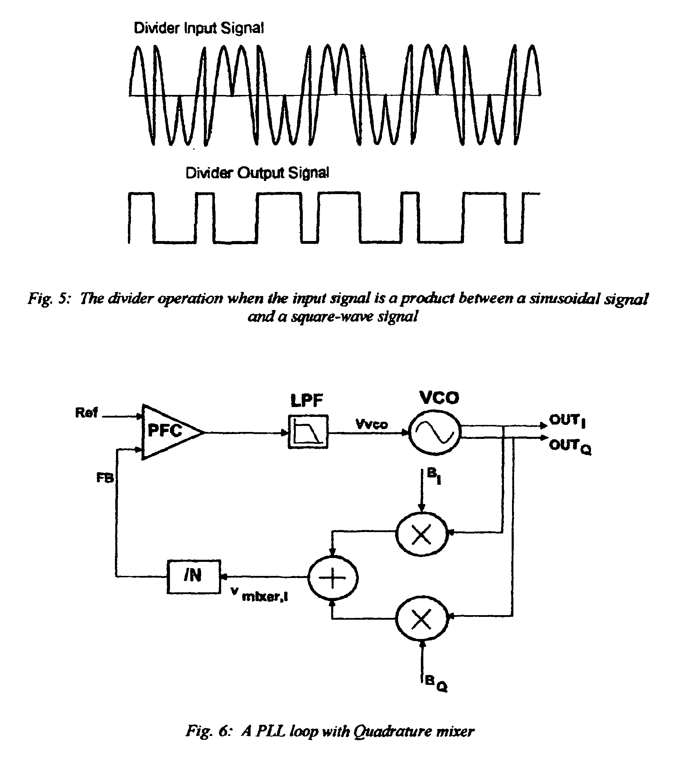

- The mixer output contains two frequencies ($f_{out} + f_B$ and $f_{out} - f_B$). It is essential that the PLL locks only to the difference frequency ($f_{out} - f_B$).
- The frequency divider (/N in Fig. 2) is a digital circuit. Its operation is shown in Fig. 3. The divider produces an output signal where the number of rising edges is N times smaller than the number of rising edges of its input signal. As a result, the divider's output signal frequency is N times smaller than its input signal frequency. However, all rising edges of the input signal are considered to determine the input signal frequency. Hence, when the input signal is a sum of two sinusoidal signals, as depicted in Fig. 4, the divider output frequency is a "strange" function of the input signal frequency, and the period of the output signal is not constant. This will create unwanted sidebands in the PLL output signal (so called phase noise or reference spurs).
- In a practical situation, the signal B is often a square wave signal instead of a sinusoidal signal. As a result, the mixer output contains a sum of signals with frequencies $f_{out} - f_B$, $f_{out} - 3f_B$, $f_{out} - 5f_B$ etc. In Fig. 5, a drawing of such a product between a sinusoidal signal and a square-wave signal is shown. Obviously, if the digital divider triggers on each zero-crossing of this signal, the divider output frequency will not be equal to $\frac{1}{N} \cdot (f_B - f_{out})$.
- As stated before, there are two possible output frequencies that produce a lock condition for the PLL. These are given by expressions (3) and (4), respectively. Whatever of these two conditions will be obtained first, will determine the end value of the PLL output frequency. The user of the circuit has no influence on the choice between these two possibilities, and it depends on "coincidence" which of both will be chosen by the PLL loop.

In the explication below, solutions to all these problems will be presented.

### Element 1: a Single-Sideband Mixer

A first element of the invention aiming to eliminate the unwanted signal, with frequency $f_{out} + f_B$ is shown in Fig. 6: In many practical situations, the VCO produces two signals with identical frequency but with a phase difference of 90°:

$$V(OUT_I) = A_{VCO} \cdot \cos(2\pi \cdot f_{OUT} \cdot t) \text{ and } V(OUT_Q) = A_{VCO} \cdot \sin(2\pi \cdot f_{OUT} \cdot t) \qquad (5)$$

In these expressions, $A_{VCO}$ is the VCO output signal amplitude.
Similary, in many practical circumstances, two signals with frequency $f_B$ are available:

$$V(B_I) = A_B \cdot \cos(2\pi \cdot f_B \cdot t) \qquad \text{and} \qquad V(B_Q) = A_B \cdot \sin(2\pi \cdot f_B \cdot t) \qquad (6)$$

The circuit of Fig. 6 creates the following signal:

$$v_{mixer,I} = V(OUT_I) \cdot V(B_I) + V(OUT_Q) \cdot V(B_Q) = A_{VCO} \cdot A_B \cdot \cos\{2\pi(f_{out} - f_B)t\} \qquad (7)$$

As can be seen, there is only one frequency present at the mixer output. It is also possible to make the following combination:

$$v_{mixer,Q} = V(OUT_I) \cdot V(B_Q) - V(OUT_Q) \cdot V(B_I) = A_{VCO} \cdot A_B \cdot \sin\{2\pi(f_B - f_{out})t\} \qquad (8)$$

This is a Single-Sideband mixer; it is well-known in the literature.

### Element 2: a Tracking filter

A second element of the invention aims to eliminate the fast transitions in the signal divider input signal of Fig. 5. These are due to the fact that the signals $v_{B,I,F}$ and $v_{B,Q}$ are square wave signals instead of sinusoidal signals. An obvious solution to this problem is to place a lowpass filter at the mixer output. In this way, the fast voltage transitions at the mixer output are filtered out, resulting in a clean sinusoidal signal. However, during the PLL lock-in process, when the PLL has not yet found the correct output frequency, the mixer output signal frequency can vary over a large range. Furthermore, in many practical cases, the PLL division factor is programmable, to generate a programmable PLL output frequency. Here also, the mixer output frequency can vary over a wide range. As a result, in some cases when the mixer output frequency is high, the signal is strongly attenuated by the filter, resulting in a filter output signal amplitude that is too low to trigger the N-divider correctly. On the other hand, when the mixer output signal frequency is low insufficient filtering will take place and the signals with frequency $f_{out}- 3 f_B$, $f_{out}- 5f_B$, etc. will not be significantly attenuated.

As a result, it is difficult to determine a value for the lowpass filter cut-off frequency that satisfies all possible conditions.

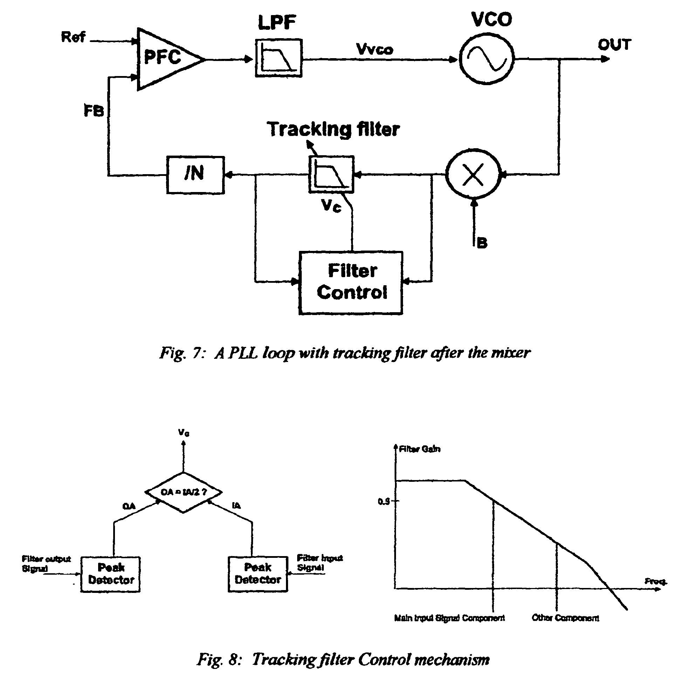

The present invention proposes a tracking filter where the cut-off frequency is continuously adapted to a value that is suited for the current situation. This is shown in Fig. 7. This figure shows a lowpass filter, where the filter cut-off frequency is determined by the signal $V_C$. This signal is controlled continuously in such a way that the filter cut-off frequency is continuously set to a correct value.

There are several techniques known in the literature to build a lowpass filter that can be controlled by a control signal (a voltage or a current). For instance, a continuous-time filter (also called a "gm-C" filter, a "transconductance-C" filter or a "gyrator" filter) is a good candidate to perform this task.

There are also several strategies possible to set the control signal $V_c$. For instance, in the circuit of Fig. 8, the filter output signal amplitude is measured with a peak detector (or an RMS detector). Similarly, the filter input signal amplitude is measured. Now, it is possible to control the voltage $v_c$ in such a way that the output signal amplitude is e.g. half the value of the input signal amplitude. In this way, the filter cut-off frequency is controlled in such a way that the filter gain is ½ for the largest signal component in the filter input signal. For signals with a higher frequency (= the unwanted signals), the filter attenuation is larger.

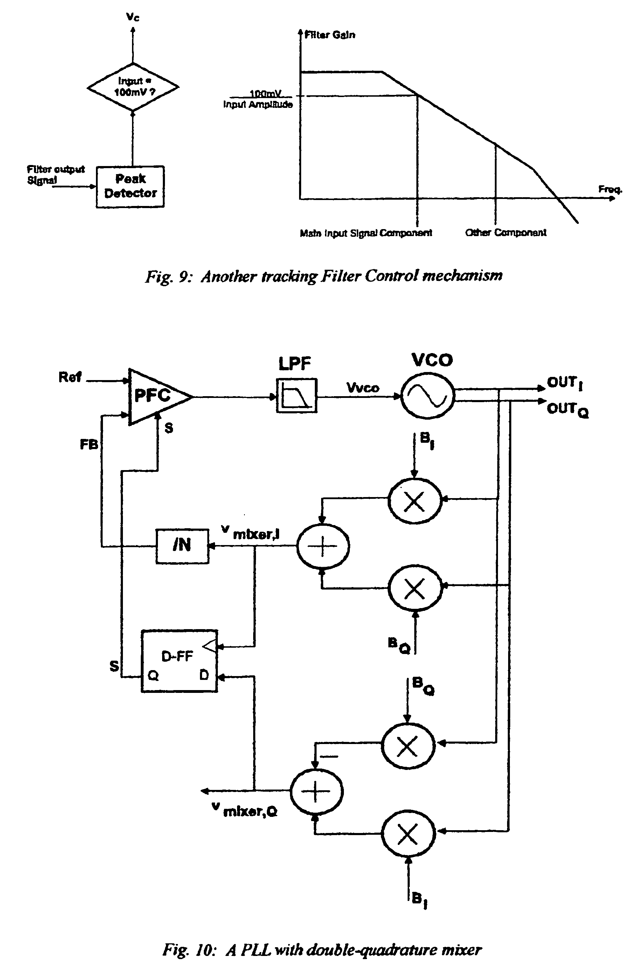

Another strategy to control the signal $V_c$ is shown in Fig. 9: The filter cut-off frequency is controlled in such a way that the output signal attains a certain amplitude. For instance, when the filter input signal amplitude is typically 500 mV, and the output signal amplitude is regulated to a value of 100 mV, the filter gain is 1/5 at the main filter input signal frequency. When the input signal frequency or amplitude varies, the filter cut-off frequency is varied to maintain a constant filter output signal amplitude. The filter attenuation for higher-frequency signal components (= the unwanted signal components) is larger.

### Element 3: a double-quadrature mixer with phase detector

As stated before, the PLL can obtain a lock condition for output frequencies that satisfy either expression (3) or (4). In Fig. 10, a circuit is shown that eliminates one of the two possibilities:

This circuit contains a double-quadrature mixer, producing two output signals according to the expressions (7) and (8):

$$V_{mixer,I} = A_{mixer} \cdot \cos\{2\pi(f_{out} - f_B)t\} \qquad (9)$$

$$V_{mixer,Q} = A_{mixer} \cdot \sin\{2\pi(f_{out} - f_B)t\} \qquad (10)$$

When $f_{out} > f_B$, $V_{mixer,I}$ has a 90° phase advance compared to $V_{mixer,Q}$: at a rising zero-crossing of $V_{mixer,I}$, $V_{mixer,Q}$ is negative. On the other hand , when $f_{out} < f_B$, $V_{mixer,I}$ has a 90° phase lag compared to $V_{mixer,Q}$ at a rising zero-crossing of $V_{mixer,I}$, $V_{mixer,Q}$ is positive Hence, the circuit of Fig. 10 allows to discriminate between these two cases: when $f_{out} > f_B$, the digital signal S is high, but when $f_{out} < f_B$, signal S is low.

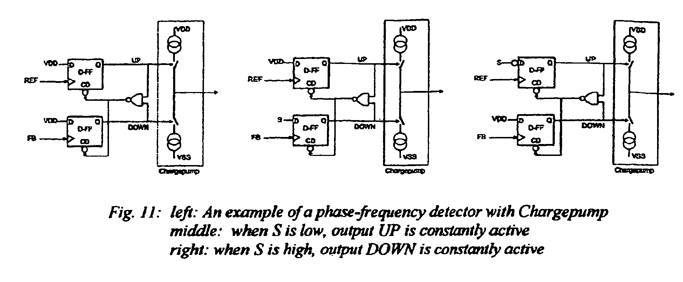

This digital signal is used to modify the behaviour of the Phase-frequency comparator. In Fig. 11 (left), an example of such a Phase-frequency comparator is shown. When signal "UP" is high, the VCO frequency is increased, while an active signal "DOWN" decreases the VCO frequency. UP and DOWN are (almost) never active simultaneously. In the circuit of Fig. 11 (middle), when S is low, the signal UP is constantly forced active while DOWN is never active. As a result, the VCO output frequency will increase until S becomes high, i.e. until $f_{out} > f_B$. Then the phase-frequency comparator resumes its normal behaviour, and the PLL output frequency will evolve to the value given by expression (3). This is the only possible stable output frequency.

In the circuit of Fig. 11 (right), the operation is reversed: when S is high, the signal UP is constantly forced inactive while DOWN is forced active. As a result, the VCO output frequency will decrease until S becomes low, i.e. until

$f_{out} < f_B$. Then the phase-frequency comparator resumes its normal behaviour, and the PLL output frequency will evolve to the value given by expression (4). This is the only possible stable output frequency.

**Claims**

1. A Phase-Locked Loop comprising a phase comparator (PFC) having a first input and a second input, a loop filter (LPF) and a voltage-controlled oscillator (VCO) coupled in series, said VCO outputting an in-phase and a quadrature signal at a first frequency, and further comprising a double-quadrature mixer, said double-quadrature mixer being fed with said in-phase and quadrature signal at said first frequency, and with an in-phase and a quadrature signal at a second frequency, said double-quadrature mixer generating an in-phase and quadrature signal at a frequency that is the difference between said first and said second frequency, either said in-phase or quadrature signal at said difference frequency further being applied to a frequency divider, the output of said frequency divider being fed to said first input of said PFC, **characterised in that** a digital signal S derived from said in-phase and quadrature signal at said difference frequency is fed to said PFC as a third input, said digital signal comprising information on whether or not said first frequency is higher than said second frequency.

2. A Phase-Locked Loop as in claim 1, wherein said information comprised in said digital signal is derived from the phase of said in-phase and quadrature signal at said difference frequency.

3. A Phase-Locked Loop as in claim 2, further comprising a digital flipflop to derive said information comprised in said digital signal.

4. A Phase-Locked Loop comprising a phase comparator (PFC) having a first input and a second input, a loop filter (LPF) and a voltage-controlled oscillator (VCO) coupled in series, and further comprising a mixer, said mixer being fed with a signal at a first frequency, said signal being output by said VCO, and with a signal at a second frequency, said mixer generating a signal at a frequency that is the difference between said first and said second frequency, **characterised in that** said signal generated by said mixer is further fed to a filter with a variable cut-off frequency, said variable cut-off frequency being controlled by a filter control signal ($V_c$), the output of said filter with variable cut-off frequency being fed to a frequency divider, said frequency divider's output being fed to sail first input of said phase comparator (PFC).

5. A Phase-Locked Loop as in claim 4, wherein said filter with a variable cut-off frequency is a gm-C filter.

6. A Phase-Locked Loop as in claim 4 or 5, wherein said filter control signal ($V_c$) is arranged for keeping the amplitude of said output of said filter with variable cut-off frequency to a given value.

7. A Phase-Locked Loop as in claim 4 or 5, wherein said filter control signal ($V_c$) is arranged for keeping the ratio between the output signal amplitude and the input signal amplitude of said filter to a given value.

**Patentansprüche**

1. Phasenregelkreis, umfassend einen Phasenkomparator (PFC) mit einem ersten Eingang und einem zweiten Eingang, ein Schleifenfilter (LPF) und einen spannungsgesteuerten Oszillator (VCO), die in Reihe gekoppelt sind, wobei der VCO ein Inphasen- und ein Quadratursignal mit einer ersten Frequenz ausgibt, und ferner umfassend einen Doppelquadraturmischer, dem das Inphasen- und Quadratursignal mit der ersten Frequenz sowie ein Inphasen- und Quadratursignal mit einer zweiten Frequenz zugeführt werden, wobei der Doppelquadraturmischer ein Inphasen- und Quadratursignal mit einer Frequenz erzeugt, die der Differenz zwischen der ersten und zweiten Frequenz entspricht, wobei entweder das Inphasen- oder das Quadratursignal mit der Differenzfrequenz ferner an einen Frequenzteiler angelegt wird, dessen Ausgang dem ersten Eingang des PFCs zugeführt wird, **dadurch gekennzeichnet, dass** ein von dem Inphasen- und Quadratursignal mit der Differenzfrequenz abgeleitetes digitales Signal S dem PFC als dritter Eingang zugeführt wird, wobei das digitale Signal Information darüber enthält, ob die erste Frequenz höher als die zweite Frequenz ist.

2. Phasenregelkreis nach Anspruch 1, wobei die in dem digitalen Signal enthaltene Information von der Phase des Inphasen- und Quadratursignals mit der Differenzfrequenz abgeleitet wird.

3. Phasenregelkreis nach Anspruch 2, ferner umfassend ein digitales Flipflop, um die in dem digitalen Signal enthaltene Information abzuleiten.

4. Phasenregelkreis, umfassend einen Phasenkomparator (PFC) mit einem ersten und einem zweiten Eingang, ein Schleifenfilter (LPF) und einen spannungsgesteuerten Oszillator (VCO), die in Reihe gekoppelt sind, und ferner umfassend einen Mischer, dem ein von dem VCO ausgegebenes Signal mit einer ersten Frequenz und ein Signal mit einer zweiten Frequenz zugeführt wird, wobei der Mischer ein Signal mit einer Frequenz erzeugt, die der Differenz zwischen der ersten und der zweiten Frequenz entspricht, **dadurch gekennzeichnet, dass** das von dem Mischer erzeugte Signal ferner einem Filter mit einer variablen Grenzfrequenz zugeführt wird, die von einem Filtersteuersignal ($V_c$) gesteuert wird, wobei der Ausgang des Filters mit der variablen Grenzfrequenz einem Frequenzteiler zugeführt wird, dessen Ausgang dem ersten Eingang des Phasenkomparators (PFC) zugeführt wird.

5. Phasenregelkreis nach Anspruch 4, wobei das Filter mit einer variablen Grenzfrequenz ein gm-C Filter ist.

6. Phasenregelkreis nach Anspruch 4 oder 5, wobei das Filtersteuersignal ($V_c$) dem Zweck dient, die Amplitude des Ausgangs des Filters mit der variablen Grenzfrequenz auf einem gegebenen Wert zu halten.

7. Phasenregelkreis nach Anspruch 4 oder 5, wobei das Filtersteuersignal ($V_c$) dem Zweck dient, das Verhältnis zwischen der Ausgangssignalamplitude und der Eingangssignalamplitude des Filters auf einem gegebenen Wert zu halten.

## Revendications

1. Boucle à verrouillage de phase comprenant un comparateur de phase (PFC) ayant une première entrée et une deuxième entrée, un filtre de boucle (LPF) et un oscillateur commandé par tension (VCO) couplés en série, ledit VCO délivrant un signal en phase et un signal en quadrature à une première fréquence, et comprenant en outre un mélangeur en double quadrature, ledit mélangeur en double quadrature étant alimenté par ledit signal en phase et ledit signal en quadrature à ladite première fréquence et par un signal en phase et un signal en quadrature à une deuxième fréquence, ledit mélangeur en double quadrature générant un signal en phase et en quadrature à une fréquence qui est la différence entre ladite première et ladite deuxième fréquence, ledit signal en phase ou ledit signal en quadrature à ladite fréquence de différence étant en outre appliqué à un diviseur de fréquence, la sortie dudit diviseur de fréquence étant acheminée à ladite première entrée dudit PFC, **caractérisée en ce qu'**un signal numérique S dérivé dudit signal en phase et dudit signal en quadrature à ladite fréquence de différence est acheminé audit PFC par une troisième entrée, ledit signal numérique comprenant des informations indiquant si ladite première fréquence est plus élevée ou non que ladite deuxième fréquence.

2. Boucle à verrouillage de phase selon la revendication 1, dans laquelle lesdites informations comprises dans ledit signal numérique sont déduites de la phase dudit signal en phase et dudit signal en quadrature à ladite fréquence de différence.

3. Boucle à verrouillage de phase selon la revendication 2, comprenant en outre une bascule bistable numérique pour déduire lesdites informations comprises dans ledit signal numérique.

4. Boucle à verrouillage de phase comprenant un comparateur de phase (PFC) ayant une première entrée et une deuxième entrée, un filtre de boucle (LPF) et un oscillateur commandé par tension (VCO) couplés en série, et comprenant en outre un mélangeur, ledit mélangeur étant alimenté par un signal à une première fréquence, ledit signal étant délivré par ledit VCO, et par un signal à une deuxième fréquence, ledit mélangeur générant un signal à une fréquence qui est la différence entre ladite première et ladite deuxième fréquence, **caractérisée en ce que** ledit signal généré par ledit mélangeur est en outre acheminé à un filtre ayant une fréquence de coupure variable, ladite fréquence de coupure variable étant commandée par un signal de commande de filtre ($V_c$), la sortie dudit filtre à fréquence de coupure variable étant acheminée à un diviseur de fréquence, ladite sortie du diviseur de fréquence étant acheminée à ladite première entrée dudit comparateur de phase (PFC).

5. Boucle à verrouillage de phase selon la revendication 4, dans laquelle ledit filtre à fréquence de coupure variable est un filtre gm-C.

6. Boucle à verrouillage de phase selon la revendication 4 ou 5, dans laquelle ledit signal de commande de filtre ($V_c$)

est aménagé pour conserver l'amplitude de ladite sortie dudit filtre à fréquence de coupure variable à une valeur donnée.

7. Boucle à verrouillage de phase selon la revendication 4 ou 5, dans laquelle ledit signal de commande de filtre (Vc) est aménagé pour conserver le rapport entre l'amplitude du signal de sortie et l'amplitude du signal d'entrée dudit filtre à une valeur donnée.

*Fig. 1: A Phase-Locked Loop*

*Fig. 2: An indirect PLL loop*

Divider Input Signal

Divider Output Signal

*Fig. 3: The operation of the Digital Divider (in this Figure, N equals 2)*

Divider Input Signal

Divider Output Signal

*Fig. 4: The divider operation when the input signal is a sum of two sinusoidal signals*

Divider Input Signal

Divider Output Signal

*Fig. 5: The divider operation when the input signal is a product between a sinusoidal signal and a square-wave signal*

*Fig. 6: A PLL loop with Quadrature mixer*

Fig. 7:  A PLL loop with tracking filter after the mixer

Fig. 8:  Tracking filter Control mechanism

*Fig. 9: Another tracking Filter Control mechanism*

*Fig. 10: A PLL with double-quadrature mixer*

*Fig. 11:* **left:** *An example of a phase-frequency detector with Chargepump*
           **middle:** *when S is low, output UP is constantly active*
           **right:** *when S is high, output DOWN is constantly active*